# EUROPEAN PATENT APPLICATION

(11) **EP 2 860 776 A1**
(43) Date of publication of application: **15.04.2015**
(21) Application number: 13804364.1
(22) Date of filing: 07.06.2013
(51) Int. Cl.: H01L 33/48

(54) **LIGHT-EMITTING DEVICE**

(30) Priority: 12.06.2012 JP 2012132799
(71) Applicant: Murata Manufacturing Co., Ltd., Nagaokakyo-shi, Kyoto 617-8555 (JP)
(72) Inventor: FUKUMITSU, Masakazu, Nagaokakyo-shi, Kyoto 617-8555 (JP); SASAKI, Hidehiko, Nagaokakyo-shi, Kyoto 617-8555 (JP); YAMAMOTO, Teiji, Nagaokakyo-shi, Kyoto 617-8555 (JP)
(74) Representative: Thoma, Michael
(86) International application number: PCT/JP2013/065798
(87) International publication number: WO 2013/187318

(57) **Abstract**

A drop in the luminous efficiency of a light-emitting element and the occurrence of mounting problems for the light-emitting element can be prevented even in a configuration in which an ESD protection element is provided within a mounting substrate. A light-emitting device (10) includes a light-emitting element (2) and a mounting substrate (11), having a first surface (11A) on which the light-emitting element (2) is mounted and a second surface (11B) that is opposite from the first surface (11A), that includes a semiconductor-based electrostatic discharge protection element portion (15) that is provided on the second surface (11B) side and is connected to the light-emitting element (2)

## Description

### Technical Field

The present invention relates to light-emitting devices including light-emitting elements and a mounting substrate on which the light-emitting elements are mounted.

### Background Art

Recent years have seen the spread of illumination devices that use semiconductor-based light-emitting diodes ("LEDs" hereinafter), which are light-emitting devices that consume little energy and have a long lifespan. An LED device used as an illumination device or the like includes an LED element, which serves as a light-emitting element, and a mounting substrate on which the LED element is mounted. The mounting substrate is configured of a ceramic such as alumina. The LED device is mounted on a circuit board that configures the illumination device.

Conventional LED devices are provided with electrostatic discharge ("ESD" hereinafter) protection elements that protect the LED elements from static electricity in order to prevent the LED elements from being damaged by such static electricity. Varistors, Zener diodes, and the like are used as ESD protection elements. In a conventional LED device, the ESD protection element is mounted on one surface of the mounting substrate along with the LED element.

However, with this type of conventional LED device, the LED element and the ESD protection element are mounted in a row on one surface of the mounting substrate, which increases the surface area of the mounting substrate, making it difficult to reduce the size of the LED device. Accordingly, an LED device in which the LED element is mounted on a first surface of the mounting substrate and the ESD protection element is mounted on a second surface that is opposite from the first surface has been proposed (see Patent Document 1, for example).

The configuration of a light-emitting device based on Patent Document 1 will be described next. Fig. 8(A) is a schematic diagram illustrating a light-emitting device 101 based on Patent Document 1. As shown in Fig. 8(A), the light-emitting device 101 includes an LED element 102, an ESD protection element 106, and a mounting substrate 110.

The LED element 102 is mounted on a first surface of the mounting substrate 110. The LED element 102 is electrically connected to an electrode on the mounting substrate 110 by a wire 104. A wall 120 is provided on the first surface of the mounting substrate 110 so as to form a space around the LED element 102. The space around the LED element 102 formed by the wall 120 is sealed by a transparent sealing material 130. The transparent sealing material 130 contains an ultraviolet absorbing agent that absorbs ultraviolet light emitted from the LED element 102, a phosphor that converts monochromatic light into white light, and so on. The ESD protection element 106 is mounted on a second surface of the mounting substrate 110 that is opposite from the first surface. The ESD protection element 106 is electrically connected to an electrode on the mounting substrate 110 by a wire 108. A second substrate 140 having an opening portion is provided on the second surface of the mounting substrate 110 so as to form a space around the ESD protection element 106. The space around the ESD protection element 106 formed by the second substrate 140 is sealed by a sealing material 150. The light-emitting device 101 is a side-view LED device.

With the light-emitting device 101, heat produced by the LED element 102 can cause the luminous efficiency of the LED element 102 to drop, the phosphor contained in the transparent sealing material 130 to degrade, and so on. As such, it is desirable to efficiently dissipate the heat produced by the LED element 102 to the exterior. However, in the light-emitting device 101, the ESD protection element 106, the second substrate 140, and the sealing material 150 are provided on the second surface of the mounting substrate 110, and thus the heat produced by the LED element 102 cannot be directly dissipated from the second surface of the mounting substrate 110. Accordingly, the light-emitting device 101 cannot avoid having poor heat dissipation properties. There is a further problem in that because the LED element 102 and the ESD protection element 106 are mounted on two respectively opposite surfaces of the mounting substrate 110, it is difficult to reduce the profile of the light-emitting device 101.

In light of these problems, an LED device in which a thermal via that passes through a mounting substrate is provided and a varistor serving as the ESD protection element is also provided on the mounting substrate has been proposed (see Patent Document 2, for example).

The configuration of a light-emitting device based on Patent Document 2 will be described next. Fig. 8(B) is a schematic diagram illustrating a light-emitting device 201 based on Patent Document 2. As shown in Fig. 8(B), the light-emitting device 201 includes a light-emitting diode element 220, a ceramic substrate 212, and a varistor portion 210. The ceramic substrate 212 serves as a mounting substrate, and includes mounting electrodes 213A and 213B, a thermal conductor portion 215, terminal electrodes 216A and 216B, an external thermal conductor portion 217, and connection electrodes 219A and 219B.

The light-emitting diode element 220 is mounted on a first surface of the ceramic substrate 212. The varistor portion 210 configures an ESD protection element, and is provided so as to enclose a region, of the first surface of the ceramic substrate 212, in which the light-emitting diode element 220 is mounted. A glass ceramic layer 214 is provided on top of the varistor portion 210.

The mounting electrodes 213A and 213B are provided on the first surface side of the ceramic substrate 212, and are connected to an electrode of the light-emitting diode element 220 by a conductive adhesive 222. The terminal electrodes 216A and 216B are provided on a second surface, that is opposite from the first surface, of the ceramic substrate 212, and are connected to the mounting electrodes 213A and 213B by the connection electrodes 219A and 219B, respectively. The thermal conductor portion 215 is provided so as to pass through the ceramic substrate 212, and is connected to the light-emitting diode element 220 by the conductive adhesive 222. In other words, the thermal conductor portion 215 serves as a thermal via. The external thermal conductor portion 217 is provided on the second surface of the ceramic substrate 212, and is connected to the thermal conductor portion 215.

In the light-emitting device 201, heat produced by the light-emitting diode element 220 can be dissipated to the exterior from the external thermal conductor portion 217 via the thermal conductor portion 215, and thus the heat dissipation properties can be improved. Furthermore, because the varistor portion 210 is provided so as to enclose a region, of the first surface of the ceramic substrate 212, in which the light-emitting diode element 220 is mounted, the size and profile of the light-emitting device 201 can be reduced.

According to the light-emitting device 201, static electricity from the exterior can flow into the varistor portion 210 via the external thermal conductor portion 217 and the thermal conductor portion 215. At this time, an electric field concentrates near an upper end, a lower end, and so on of the thermal conductor portion 215, resulting in a problem that it is easy for metal meltdown to occur in the thermal conductor portion 215. Although providing a plurality of thermal conductor portions, increasing the size of the thermal conductor portion, and so on can be considered as a way of preventing such metal meltdown from occurring in the thermal conductor portion due to such electric field concentration, doing so makes it difficult to reduce the size of the light-emitting device.

Accordingly, an LED device that employs a mounting substrate configured of silicon, whose thermal conductivity is higher than a ceramic such as alumina, and provides a Zener diode within the mounting substrate as an ESD protection element has been proposed (see Patent Document 3, for example).

The configuration of a light-emitting device based on Patent Document 3 will be described next. Fig. 8(C) is a schematic diagram illustrating a light-emitting device 301 based on Patent Document 3. As shown in Fig. 8(C), the light-emitting device 301 includes a light-emitting element 311 and a Zener diode 321.

The light-emitting element 311 includes a sapphire substrate 312, a semiconductor compound layer 313, an n-side electrode 314, and a p-side electrode 315. The semiconductor compound layer 313 is formed on the sapphire substrate 312, and is configured of a plurality of layers containing an InGaN active layer, serving as a light-emitting layer. The n-side electrode 314 and the p-side electrode 315 are provided on a surface of the semiconductor compound layer 313 that is opposite from the surface thereof located toward the sapphire substrate 312. The n-side electrode 314 is provided on an n-type layer formed as a single layer in the semiconductor compound layer 313. The p-side electrode 315 is provided in a p-type layer formed as a single layer in the semiconductor compound layer 313. A micro bump 316 is affixed to the n-side electrode 314, and a micro bump 317 is affixed to the p-side electrode 315.

The Zener diode 321 is configured as a mounting substrate having an n-type silicon substrate 322 as a base material. An n-side electrode 323 is provided on a base surface of the n-type silicon substrate 322. An oxidant film 324 that covers a partial region of the surface of the n-type silicon substrate 322 is provided on a top surface of the n-type silicon substrate 322. A p-type semiconductor region 325 and an n-side electrode 327 are respectively provided in regions of the surface of the n-type silicon substrate 322 that are not covered by the oxidant film 324. A p-side electrode 326 is provided on a top surface of the p-type semiconductor region 325. The p-type semiconductor region 325 and the n-type silicon substrate 322 form a p-n junction in the Zener diode 321.

The Zener diode 321 is mounted on a mount portion 331, which corresponds to an external circuit board, using a conductive Ag paste 332. The light-emitting element 311 is mounted upon the Zener diode 321 via the micro bumps 316 and 317. A wire 333 is connected to the p-side electrode 326.

In the light-emitting device 301, the Zener diode 321 that serves as the mounting substrate uses as its base material the n-type silicon substrate 322 that is configured of silicon, which has a higher thermal conductivity than a ceramic such as alumina; as such, heat produced by the light-emitting element 311 can be efficiently dissipated. Meanwhile, because the Zener diode 321 functions as an ESD protection element, a separate ESD protection element need not be provided, which makes it possible to reduce the size of the light-emitting device.

### Citation List

### Patent Documents

Patent Document 1: Japanese Unexamined Patent Application Publication No. 2007-36238
Patent Document 2: Japanese Unexamined Patent Application Publication No. 2008-270327
Patent Document 3: Japanese Unexamined Patent Application Publication No. 11-251644

### Summary of Invention

### Technical Problem

In a light-emitting device such as the light-emitting devices 201 and 301, in which the ESD protection element is configured of a varistor portion, a Zener diode, or the like, the temperature of the ESD protection element may rise due to the heat produced by the light-emitting element and an increase in leaked current may result in the case where the ESD protection element is provided near the light-emitting element. An increase in leaked current in the ESD protection element can cause a drop in the luminous efficiency of the light-emitting element.

In the light-emitting device 301, if the Zener diode 321 serving as the ESD protection element is exposed to light emitted from the light-emitting element 311, ambient light from the surroundings, or the like, there will be an increase in leaked current in the Zener diode 321, which also may lead to a drop in the luminous efficiency of the light-emitting element 311.

Furthermore, in the case where the light-emitting element is flip-chip mounted on the mounting substrate, a flatness of no more than several µm is required in the mounting surface of the mounting substrate in order to prevent the occurrence of mounting problems. However, in the case where the mounting substrate is configured of a ceramic material, as with the light-emitting device 201, the mounting surface of the mounting substrate has a low level of flatness and it is thus easy for mounting problems to occur. The level of flatness of the mounting surface of the mounting substrate is even lower in the case where thermal vias such as the thermal conductor portion 215 are provided, as in the light-emitting device 201. Furthermore, the level of flatness in the mounting surface of the mounting substrate is low, and mounting problems occur with ease as a result, even in the case where an ESD protection element is provided on the surface of the mounting substrate on which the light-emitting element is mounted, as in the light-emitting device 301. Although the mounting surface of the mounting substrate can be flattened through chemical mechanical polishing in order to increase the level of flatness of the mounting surface of the mounting substrate, doing so has problems, for example, in that the manufacturing process is complicated and manufacturing costs rise as a result.

Accordingly, it is an object of the present invention to provide a light-emitting device capable of preventing a drop in the luminous efficiency of a light-emitting element and preventing the occurrence of mounting problems for the light-emitting element, even in a configuration in which an ESD protection element is provided within a mounting substrate.

### Solution to Problem

A light-emitting device according to the present invention includes a light-emitting element and a mounting substrate. The mounting substrate has a first surface on which the light-emitting element is mounted and a second surface that is opposite from the first surface. The mounting substrate includes a semiconductor-based electrostatic discharge protection element portion that is provided on the second surface side and is connected to the light-emitting element.

In the light-emitting device according to the present invention, the light-emitting element may be a semiconductor light-emitting diode element having an anode and a cathode, the semiconductor-based electrostatic discharge protection element portion may configure a Zener diode that includes an anode and a cathode, the semiconductor light-emitting diode element and the Zener diode may be connected in parallel, and the cathode of the semiconductor light-emitting diode element may be connected to the anode of the Zener diode and the anode of the semiconductor light-emitting diode element may be connected to the cathode of the Zener diode.

In the light-emitting device according to the present invention, the light-emitting element may be a semiconductor light-emitting diode element having an anode and a cathode, the semiconductor-based electrostatic discharge protection element portion may configure a varistor, and the semiconductor light-emitting diode element and the varistor may be connected in parallel.

### Advantageous Effects of Invention

According to the present invention, the semiconductor-based electrostatic discharge protection element portion is provided on the second surface side of the mounting substrate, and is thus sufficiently distanced from the light-emitting element. Accordingly, the semiconductor-based electrostatic discharge protection element portion is not easily influenced by heat produced by the light-emitting element, and it is thus difficult for leaked current to increase in the semiconductor-based electrostatic discharge protection element portion. Light emitted from the light-emitting element, ambient light from the surroundings, and the like are blocked by the mounting substrate, which reduces instances of the semiconductor-based electrostatic discharge protection element portion being exposed to such light. Accordingly, it is difficult for an increase in leaked current to occur in the semiconductor-based electrostatic discharge protection element portion due to the light emitted from the light-emitting element, the ambient light from the surroundings, and so on. As such, a high luminous efficiency can be maintained in the light-emitting element. Furthermore, because the semiconductor-based electrostatic discharge protection element portion is not provided on the first surface side of the mounting substrate, the first surface has a high level of flatness. The bonding strength between the light-emitting element and the mounting substrate can therefore be increased, which makes it possible to prevent the occurrence of mounting problems in the light-emitting element.

### Brief Description of Drawings

[Fig. 1] Fig. 1 is an equivalent circuit diagram illustrating a light-emitting device according to a first embodiment of the present invention.
[Fig. 2] Fig. 2 is a diagram illustrating the configuration of a light-emitting device according to the first embodiment of the present invention.
[Fig. 3] Fig. 3 is a diagram illustrating the structure of a semiconductor element portion in the light-emitting device according to the first embodiment of the present invention.
[Fig. 4] Fig. 4 shows diagrams illustrating the configuration of a light-emitting device according to a second embodiment of the present invention.
[Fig. 5] Fig. 5 is a diagram illustrating the configuration of a light-emitting device according to a third embodiment of the present invention.
[Fig. 6] Fig. 6 is a diagram illustrating the configuration of a light-emitting device according to a fourth embodiment of the present invention.
[Fig. 7] Fig. 7 is a diagram illustrating the configuration of a light-emitting device according to a fifth embodiment of the present invention.

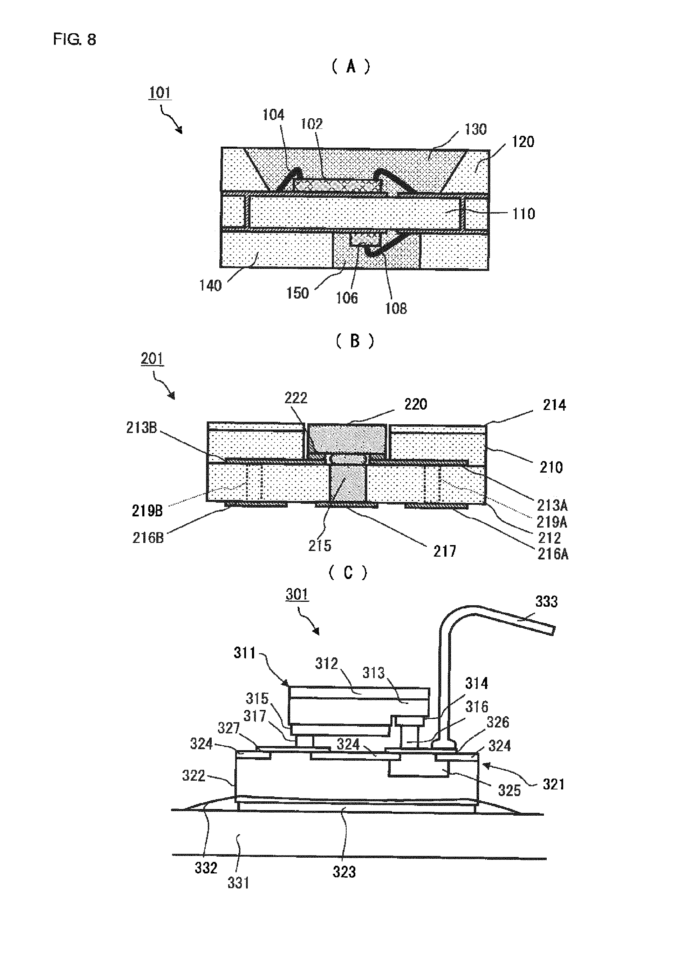

[Fig. 8] Fig. 8 shows diagrams illustrating examples of the configurations of conventional light-emitting devices.

### Description of Embodiments

A light-emitting device according to a first embodiment of the present invention will be described hereinafter.

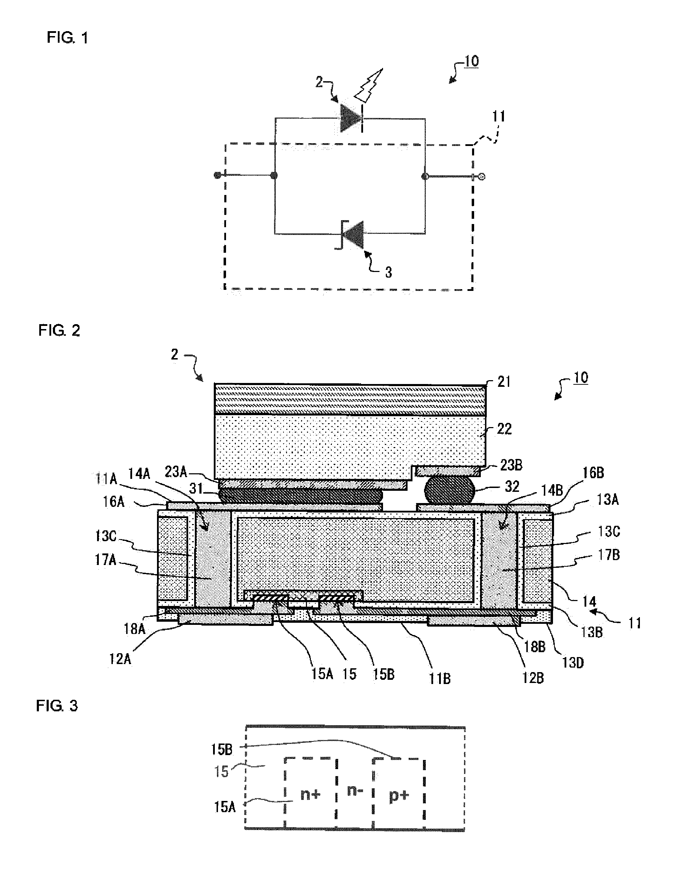

Fig. 1 is an equivalent circuit diagram illustrating a light-emitting device 10 according to the first embodiment of the present invention.

The light-emitting device 10 according to the present embodiment includes an LED element 2 serving as a light-emitting element and a mounting substrate 11. The mounting substrate 11 contains a Zener diode 3. The LED element 2 is mounted on the mounting substrate 11 and is connected to the Zener diode 3 in parallel. Here, a cathode of the LED element 2 is connected to an anode of the Zener diode 3, and an anode of the LED element 2 is connected to a cathode of the Zener diode 3. The Zener diode 3 protects the LED element 2 from static electricity. In other words, the Zener diode 3 is a semiconductor-based electrostatic discharge protection element portion.

Fig. 2 is a schematic diagram illustrating the configuration of the light-emitting device 10 according to the present embodiment. Fig. 2 illustrates a cross-section of the mounting substrate 11 and a side surface of the LED element 2.

The LED element 2 includes a sapphire substrate 21, a semiconductor compound layer 22, a first element terminal electrode 23A, and a second element terminal electrode 23B.

The semiconductor compound layer 22 is provided on the sapphire substrate 21. The semiconductor compound layer 22 is configured of a plurality of layers, including an InGaN active layer (not shown) serving as a light-emitting layer, a p-type semiconductor layer (not shown), and an n-type semiconductor layer (not shown). The p-type semiconductor layer (not shown) and the n-type semiconductor layer (not shown) are provided in the semiconductor compound layer 22 so as to be exposed from a surface thereof that is opposite from the surface located toward the sapphire substrate 21. The first element terminal electrode 23A is provided on the p-type semiconductor layer (not shown) that is exposed from the surface of the semiconductor compound layer 22 that is opposite from the surface located toward the sapphire substrate 21. The second element terminal electrode 23B is provided on the n-type semiconductor layer (not shown) that is exposed from the surface of the semiconductor compound layer 22 that is opposite from the surface located toward the sapphire substrate 21.

The first element terminal electrode 23A functions as the anode of the LED element 2, and a bump 31 is joined thereto. The second element terminal electrode 23B functions as the cathode of the LED element 2, and a bump 32 is joined thereto. The first and second element terminal electrodes 23A and 23B are layered electrodes in which, for example, a gold film, a nickel film, a titanium film, and a copper film are layered in that order.

The mounting substrate 11 includes a first terminal electrode 12A, a second terminal electrode 12B, insulating films 13A, 13B, 13C, and 13D, a silicon base portion 14, a semiconductor element portion 15, a first mounting electrode 16A, a second mounting electrode 16B, a first connection electrode 17A, a second connection electrode 17B, a first wiring electrode 18A, and a second wiring electrode 18B.

The mounting substrate 11 has a first surface 11A and a second surface 11B that is opposite from the first surface 11A. The LED element 2 is mounted on a first surface 11A of the mounting substrate 11.

The silicon base portion 14 has a rectangular plate shape when viewed from above, and is configured of high-resistance single-crystal silicon. Because the silicon base portion 14 of which the mounting substrate 11 is configured is a single-crystal silicon, the mounting substrate 11 has a high thermal conductivity. Accordingly, in the light-emitting device 10, heat produced by the LED element 2 can be efficiently dissipated to the exterior, and thus it is difficult for a drop in the luminous efficiency of the LED element 2 and degradation in a phosphor (not shown) provided in the LED element 2 to occur. The silicon base portion 14 has through-holes 14A and 14B.

The insulating films 13A, 13B, 13C, and 13D are configured of an insulative material such as glass. The insulating film 13A is provided on the first surface 11A side of the mounting substrate 11, so as to cover areas of the silicon base portion 14 excluding the through-holes 14A and 14B. The insulating film 13B is provided on the second surface 11B side of the mounting substrate 11, so as to cover areas of the silicon base portion 14 excluding the through-holes 14A and 14B as well as first and second diffusion regions 15A and 15B, which will be described in detail later. The insulating film 13C is provided so as to cover the entire inner circumferential surfaces of the through-holes 14A and 14B. The insulating film 13D is provided on the second surface 11B side of the mounting substrate 11 so as to cover part of the insulating film 13B and part of the first and second wiring electrodes 18A and 18B.

The first connection electrode 17A is provided so as to fill an interior portion of the through-hole 14A, and is electrically connected to the first mounting electrode 16A and the first wiring electrode 18A. The second connection electrode 17B is provided so as to fill an interior portion of the through-hole 14B, and is electrically connected to the second mounting electrode 16B and the second wiring electrode 18B.

The first and second connection electrodes 17A and 17B may instead be provided as films that cover the inner circumferential surfaces of the through-holes 14A and 14B. In this case, a resin may further be provided so as to fill the interior portions of the through-holes 14A and 14B.

The first terminal electrode 12A is provided on the second surface 11B side of the mounting substrate 11 so as to cover part of the first wiring electrode 18A, and is connected to the first wiring electrode 18A. The second terminal electrode 12B is provided on the second surface 11B side of the mounting substrate 11 so as to cover part of the second wiring electrode 18B, and is connected to the second wiring electrode 18B. The first and second terminal electrodes 12A and 12B are connected to electrodes of a circuit board on which the light-emitting device 10 is mounted. The first and second terminal electrodes 12A and 12B are layered electrodes in which, for example, a gold film, a nickel film, and a copper film are layered in that order.

The first and second mounting electrodes 16A and 16B are provided for mounting the LED element 2. The first mounting electrode 16A is provided on the first surface 11A side of the mounting substrate 11 so as to cover part of the insulating film 13A and all of the first connection electrode 17A. Accordingly, the first mounting electrode 16A is connected to the first connection electrode 17A. The first mounting electrode 16A is electrically connected to the first element terminal electrode 23A by the bump 31. The second mounting electrode 16B is provided on the first surface 11A side of the mounting substrate 11 so as to cover part of the insulating film 13A and all of the second connection electrode 17B. Accordingly, the second mounting electrode 16B is connected to the second connection electrode 17B. The second mounting electrode 16B is electrically connected to the second element terminal electrode 23B by the bump 32. The first and second mounting electrodes 16A and 16B are layered electrodes in which, for example, a gold film, a nickel film, a titanium film, and a copper film are layered in that order.

The first wiring electrode 18A is provided on the second surface 11B side of the mounting substrate 11 so as to cover the first connection electrode 17A and the first diffusion region 15A, and is connected to the first connection electrode 17A and the first diffusion region 15A.

The second wiring electrode 18B is provided on the second surface 11B side of the mounting substrate 11 so as to cover the second connection electrode 17B and the second diffusion region 15B, and is connected to the second connection electrode 17B and the second diffusion region 15B.

The semiconductor element portion 15 configures the Zener diode 3, which serves as the semiconductor-based electrostatic discharge protection element portion. The semiconductor element portion 15 is provided on the second surface 11B side of the mounting substrate 11, and includes the first diffusion region 15A and the second diffusion region 15B.

Next, an example of the configuration of the semiconductor element portion 15 will be described.

Fig. 3 is a diagram illustrating the structure of the semiconductor element portion 15 in the light-emitting device 10 according to the present embodiment.

The semiconductor element portion 15 includes an n-type semiconductor region (n-) having a low impurity concentration. The first and second diffusion regions 15A and 15B are formed by doping areas near the surface of the n-type semiconductor region (n-) with a dopant. The first diffusion region 15A is an n-type semiconductor region (n+) having a high impurity concentration. The second diffusion region 15B is a p-type semiconductor region (p+) having a high impurity concentration. The first diffusion region 15A and the second diffusion region 15B are disposed with an interval provided therebetween. In the semiconductor element portion 15, the Zener diode 3 is configured as a PIN diode, by the second diffusion region 15B that is a p-type semiconductor region (p+), a portion of the n-type semiconductor region (n-), which is an insulative material layer, located between the first diffusion region 15A and the second diffusion region 15B, and the first diffusion region 15A that is an n-type semiconductor region (n+). Accordingly, the second diffusion region 15B serves as the anode of the Zener diode 3 and the first diffusion region 15A serves as the cathode of the Zener diode 3.

Note that in the semiconductor element portion 15, the first diffusion region 15A and the second diffusion region 15B may be configured so as to be adjacent to each other without an interval provided therebetween by the insulative material layer. In this case, in the semiconductor element portion 15, the Zener diode 3 is configured as a PN diode, by the second diffusion region 15B that is a p-type semiconductor region (p+) and the first diffusion region 15A that is an n-type semiconductor region (n+).

Meanwhile, in the semiconductor element portion 15, the polarities of the first diffusion region 15A and the second diffusion region 15B may be switched, or the polarity of the insulative material layer may be inverted. In the case where the polarities of the first diffusion region 15A and the second diffusion region 15B are to be switched, the anode and cathode of the Zener diode 3 are also switched, and thus it is preferable to switch the anode and cathode of the LED element 2 as well.

As shown in Fig. 2, the first diffusion region 15A is connected to the first terminal electrode 12A via the first wiring electrode 18A. Meanwhile, the first diffusion region 15A is connected to the first mounting electrode 16A via the first wiring electrode 18A and the first connection electrode 17A. The first mounting electrode 16A, the first wiring electrode 18A, the first connection electrode 17A, and the first terminal electrode 12A configure a first wiring portion. The first element terminal electrode 23A, which serves as the anode of the LED element 2, and the first diffusion region 15A, which serves as the cathode of the Zener diode, are connected by the first wiring portion.

As shown in Fig. 2, the second diffusion region 15B is connected to the second terminal electrode 12B via the second wiring electrode 18B. Meanwhile, the second diffusion region 15B is connected to the second mounting electrode 16B via the second wiring electrode 18B and the second connection electrode 17B. The second mounting electrode 16B, the second wiring electrode 18B, the second connection electrode 17B, and the second terminal electrode 12B configure a second wiring portion. The second element terminal electrode 23B, which serves as the cathode of the LED element 2, and the second diffusion region 15B, which serves as the anode of the Zener diode, are connected by the second wiring portion.

Accordingly, the LED element 2 and the Zener diode 3 configured of the semiconductor element portion 15 are connected in parallel with the cathodes and the anodes thereof facing in mutually opposite directions, and the circuit configuration shown in Fig. 1 is realized as a result. According to this circuit configuration, the Zener diode 3, which functions as an ESD protection circuit for the LED element 2, is configured of the semiconductor element portion 15, and thus has favorable electrostatic resistance.

In the light-emitting device 10, the semiconductor element portion 15 is provided on the second surface 11B side of the mounting substrate 11, and is therefore sufficiently distanced from the LED element 2. Accordingly, the semiconductor element portion 15 is not easily affected by heat produced by the LED element 2, and it is thus difficult for an increase in leaked current to occur in the Zener diode 3, which is configured of the semiconductor element portion 15. Light emitted from the LED element 2, ambient light from the surroundings, and the like are blocked by the mounting substrate 11, which reduces instances of the semiconductor element portion 15 being exposed to such light. Accordingly, in the light-emitting device 10, it is difficult for an increase in leaked current to occur in the Zener diode 3, which is configured of the semiconductor element portion 15, due to the light emitted from the LED element 2 and the ambient light from the surroundings. As such, a high luminous efficiency can be maintained in the LED element 2.

Furthermore, according to the light-emitting device 10, the semiconductor element portion 15 is not provided on the first surface 11A side of the mounting substrate 11, and thus the first surface 11A has a high level of flatness. The bonding strength between the LED element 2 and the mounting substrate 11 can therefore be increased, which makes it possible to prevent the occurrence of mounting problems in the LED element 2.

Although the present embodiment describes a circuit configuration in which the LED element 2 and the Zener diode 3 are connected in parallel, the configuration may be such that a grounding terminal electrode is provided on the second surface 11B of the mounting substrate 11 and one end of the Zener diode is connected to the grounding terminal electrode.

A light-emitting device 40 according to a second embodiment of the present invention will be described hereinafter.

Although the semiconductor element portion 15 configures the Zener diode 3 in the light-emitting device 10 according to the first embodiment, a semiconductor element portion configures a varistor in the light-emitting device according to the present embodiment.

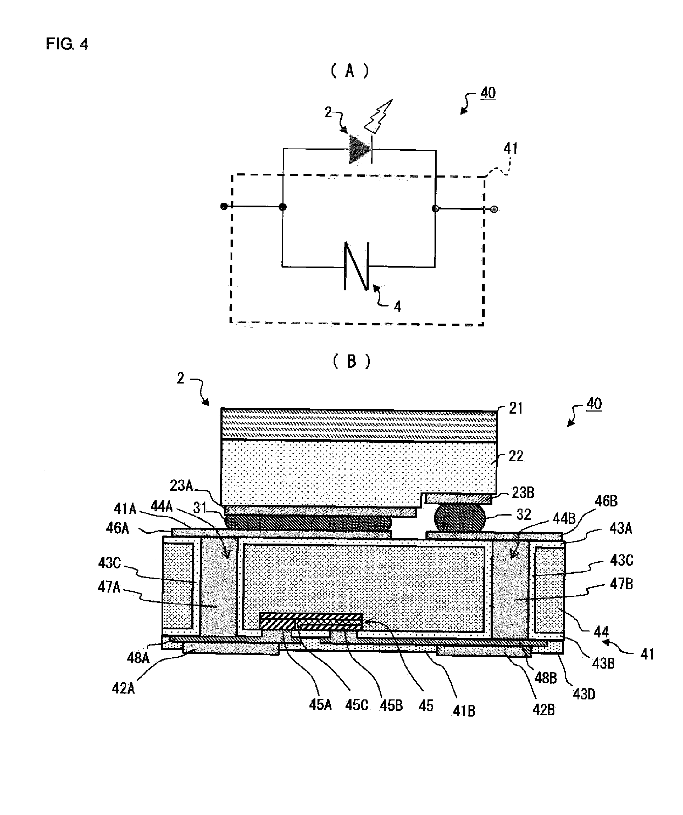

Fig. 4(A) is an equivalent circuit diagram illustrating the light-emitting device 40 according to the second embodiment of the present invention.

The light-emitting device 40 according to the present embodiment includes the LED element 2 serving as a light-emitting element and a mounting substrate 41. The mounting substrate 41 contains a varistor 4. The LED element 2 is mounted on the mounting substrate 41 and is connected in parallel to the varistor 4. The varistor 4 protects the LED element 2 from static electricity. In other words, the varistor 4 is a semiconductor-based electrostatic discharge protection element portion.

Fig. 4(B) illustrates a cross-section of the mounting substrate 41 and a side surface of the LED element 2 in the light-emitting device 40 according to the present embodiment.

The mounting substrate 41 includes a first terminal electrode 42A, a second terminal electrode 42B, insulating films 43A, 43B, 43C, and 43D, a ceramic base portion 44, a semiconductor element portion 45, a first mounting electrode 46A, a second mounting electrode 46B, a first connection electrode 47A, a second connection electrode 47B, a first wiring electrode 48A, and a second wiring electrode 48B. The mounting substrate 41 differs from the mounting substrate 11 in the light-emitting device 10 according to the first embodiment only in the configurations of the ceramic base portion 44 and the semiconductor element portion 45. As such, the first terminal electrode 42A, the second terminal electrode 42B, the insulating films 43A, 43B, 43C, and 43D, the first mounting electrode 46A, the second mounting electrode 46B, the first connection electrode 47A, the second connection electrode 47B, the first wiring electrode 48A, and the second wiring electrode 48B are the same as in the first embodiment.

The ceramic base portion 44 has a rectangular plate shape when viewed from above, and is configured of a ceramic such as alumina. The ceramic base portion 44 has through-holes 44A and 44B. The semiconductor element portion 45 configures the varistor 4, which serves as the semiconductor-based electrostatic discharge protection element portion. The semiconductor element portion 45 is provided on a second surface 41B side of the mounting substrate 41, and includes a first varistor electrode 45A, a second varistor electrode 45B, and a varistor layer 45C. The varistor layer 45C is configured of a varistor material such as zinc oxide, strontium titanate, or the like, and is provided between the first varistor electrode 45A and the second varistor electrode 45B.

The first varistor electrode 45A is connected to the first terminal electrode 42A via the first wiring electrode 48A. Meanwhile, the first varistor electrode 45A is connected to the first mounting electrode 46A via the first wiring electrode 48A and the first connection electrode 47A. The first mounting electrode 46A, the first wiring electrode 48A, the first connection electrode 47A, and the first terminal electrode 42A configure a first wiring portion. The first element terminal electrode 23A, which serves as the anode of the LED element 2, and the first varistor electrode 45A are connected by the first wiring portion.

The second varistor electrode 45B is connected to the second terminal electrode 42B via the second wiring electrode 48B. Meanwhile, the second varistor electrode 45B is connected to the second mounting electrode 46B via the second wiring electrode 48B and the second connection electrode 47B. The second mounting electrode 46B, the second wiring electrode 48B, the second connection electrode 47B, and the second terminal electrode 42B configure a second wiring portion. The second element terminal electrode 23B, which serves as the cathode of the LED element 2, and the second varistor electrode 45B are connected by the second wiring portion.

Accordingly, the LED element 2 and the varistor 4 configured of the semiconductor element portion 45 are connected in parallel, and the circuit configuration shown in Fig. 4(A) is realized as a result. According to this circuit configuration, the varistor 4, which functions as an ESD protection circuit for the LED element 2, is configured of the semiconductor element portion 45, and thus has favorable electrostatic resistance.

As described in the present embodiment, the semiconductor element portion may configure a varistor.

Although the LED element 2 and the varistor 4 configured of the semiconductor element portion 45 are connected in parallel in the present embodiment, it should be noted that the configuration may be such that a grounding terminal electrode is provided on the second surface 41B of the mounting substrate 41 and the first varistor electrode 45A or the second varistor electrode 45B is connected to the grounding terminal electrode. Furthermore, the configuration may be such that two varistors are prepared, one end of each of the varistors is connected to the first element terminal electrode 23A and the second element terminal electrode 23B of the LED element 2, respectively, and the other ends of the varistors are connected to the grounding terminal electrode provided on the second surface 41B of the mounting substrate 41.

A light-emitting device 50 according to a third embodiment of the present invention will be described hereinafter.

Although the light-emitting device 50 according to the present embodiment has the same circuit configuration as the light-emitting device 10 according to the first embodiment, the configurations of the semiconductor element portion and the first and second wiring electrodes are different. As such, although the light-emitting device 50 includes a mounting substrate 51 whose configuration is different from that of the mounting substrate 11 in the light-emitting device 10, the other configurations are almost identical.

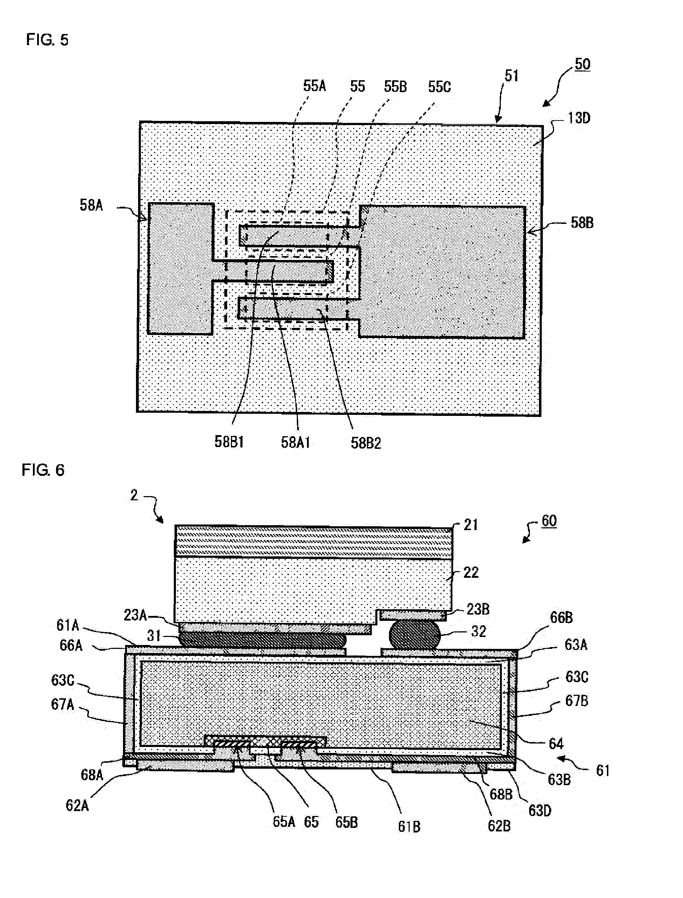

The light-emitting device 50 according to the present embodiment includes an LED element and the mounting substrate 51. Like the mounting substrate 11 in the light-emitting device 10 according to the first embodiment, the mounting substrate 51 includes first and second mounting electrodes provided for mounting the LED element. Fig. 5 is a see-through plan view illustrating the LED element and the first and second mounting electrodes in the light-emitting device 50 according to the present embodiment from above. The LED element and the first and second mounting electrodes are not shown in Fig. 5. The mounting substrate 51 includes a semiconductor element portion 55.

While the semiconductor element portion 15 in the light-emitting device 10 according to the first embodiment includes the first and second diffusion regions 15A and 15B, the semiconductor element portion 55 includes a first diffusion region 55A, a second diffusion region 55B, and a third diffusion region 55C. The first to third diffusion regions 55A to 55C each have rectangular shapes when viewed from above, and are arranged with intervals provided therebetween. The semiconductor element portion 55 includes an n-type semiconductor region (n-) having a low impurity concentration. The first to third diffusion regions 55A to 55C are formed by doping areas near the surface of the n-type semiconductor region (n-) with a dopant. The second diffusion region 55B located in the center includes an n-type semiconductor region (n+) having a high impurity concentration. Each of the first and third diffusion regions 55A and 55C located on the respective sides of the second diffusion region 55B includes a p-type semiconductor region (p+) having a high impurity concentration. An area of the n-type semiconductor region (n-) located between the first diffusion region 55A and the second diffusion region 55B and an area of the n-type semiconductor region (n-) located between the second diffusion region 55B and the third diffusion region 55C serve as an insulative material layer. In the semiconductor element portion 55, a first PIN diode is configured by the first diffusion region 55A that is a p-type semiconductor region (p+), a portion of the n-type semiconductor region (n-) located between the first diffusion region 55A and the second diffusion region 55B, and the second diffusion region 55B that is an n-type semiconductor region (n+), and a second PIN diode is configured by the third diffusion region 55C that is a p-type semiconductor region (p+), a portion of the n-type semiconductor region (n-) located between the third diffusion region 55C and the second diffusion region 55B, and the second diffusion region 55B that is an n-type semiconductor region (n+). The first and second PIN diodes configure a Zener diode.

First and second wiring electrodes 58A and 58B are shaped so as to have comb-tooth shaped portions. The first wiring electrode 58A includes a comb-tooth electrode 58A1. The comb-tooth electrode 58A1 has a rectangular shape when viewed from above, and is provided so as to protrude from part of the first wiring electrode 58A. The comb-tooth electrode 58A1 is provided so as to cover the second diffusion region 55B, and is connected to the second diffusion region 55B.

The second wiring electrode 58B includes comb-tooth electrodes 58B1 and 58B2. The comb-tooth electrodes 58B1 and 58B2 have rectangular shapes when viewed from above, and are provided so as to protrude from part of the second wiring electrode 58B. The comb-tooth electrode 58B1 is provided so as to cover the first diffusion region 55A, and is connected to the first diffusion region 55A. The comb-tooth electrode 58B2 is provided so as to cover the third diffusion region 55C, and is connected to the third diffusion region 55C.

According to the light-emitting device 50, two PIN diodes are configured in the semiconductor element portion 55, which makes it possible to increase the current capacity of the Zener diode configured by the semiconductor element portion 55; as such, even if a large current flows through the Zener diode, the Zener diode will not be damaged by that current.

Although the present embodiment describes an example in which two PIN diodes are configured in the semiconductor element portion, it should be noted that multiple PIN diodes, PN diodes, or the like may be configured by providing a greater number of comb-tooth electrodes and diffusion regions.

A light-emitting device 60 according to a fourth embodiment of the present invention will be described hereinafter.

Although the light-emitting device 60 according to the present embodiment has the same circuit configuration as the light-emitting device 10 according to the first embodiment, the configurations of electrodes in the mounting substrate are different. As such, although the light-emitting device 60 includes a mounting substrate 61 whose configuration is different from that of the mounting substrate 11 in the light-emitting device 10, the other configurations are almost identical.

Fig. 6 is a schematic cross-sectional view illustrating the light-emitting device 60 according to the present embodiment, and illustrates a cross-section of the mounting substrate 61 and a side surface of the LED element 2.

The light-emitting device 60 according to the present embodiment includes the LED element 2 and the mounting substrate 61. The mounting substrate 61 has a first surface 61A and a second surface 61B that is opposite from the first surface 61A. The mounting substrate 61 includes a first terminal electrode 62A, a second terminal electrode 62B, insulating films 63A, 63B, 63C, and 63D, a silicon base portion 64, a semiconductor element portion 65, a first mounting electrode 66A, a second mounting electrode 66B, a first connection electrode 67A, a second connection electrode 67B, a first wiring electrode 68A, and a second wiring electrode 68B.

The semiconductor element portion 65 is configured in the same manner as the semiconductor element portion 15 in the light-emitting device 10 according to the first embodiment, and includes a first diffusion region 65A and a second diffusion region 65B that configure a Zener diode serving as the semiconductor-based electrostatic discharge protection element portion. The silicon base portion 64 has a rectangular plate shape when viewed from above, and is configured of high-resistance single-crystal silicon. While the silicon base portion 14 in the light-emitting device 10 according to the first embodiment has the through-holes 14A and 14B, the silicon base portion 64 does not have through-holes.

The insulating films 63A, 63B, 63C, and 63D are configured of an insulative material such as glass. The insulating film 63A is provided on the first surface 61A side of the mounting substrate 61, so as to cover the surface of the silicon base portion 64. The insulating film 63B is provided on the second surface 61B side of the mounting substrate 61, so as to cover areas excluding the first and second diffusion regions 65A and 65B. The insulating film 63C is provided so as to cover a side surface of the silicon base portion 64. The insulating film 63D is provided on the second surface 61B side of the mounting substrate 61 so as to cover part of the insulating film 63B and part of the first and second wiring electrodes 68A and 68B.

The first and second mounting electrodes 66A and 66B have the same configurations as the first and second mounting electrodes 16A and 16B in the light-emitting device 10 according to the first embodiment, and are provided for mounting the LED element 2. The first mounting electrode 66A is provided on the first surface 61A side of the mounting substrate 61 so as to cover part of the insulating film 63A and the first connection electrode 67A. Accordingly, the first mounting electrode 66A is connected to the first connection electrode 67A. The first mounting electrode 66A is electrically connected to the first element terminal electrode 23A by the bump 31. The second mounting electrode 66B is provided on the first surface 61A side of the mounting substrate 61 so as to cover part of the insulating film 63A and the second connection electrode 67B. Accordingly, the second mounting electrode 66B is connected to the second connection electrode 67B. The second mounting electrode 66B is electrically connected to the second element terminal electrode 23B by the bump 32.

The first connection electrode 67A is provided on a side surface side of the mounting substrate 61 so as to cover the insulating film 63C, and is electrically connected to the first mounting electrode 66A and the first wiring electrode 68A. The second connection electrode 67B is provided on a side surface side of the mounting substrate 61 so as to cover the insulating film 63C, and is electrically connected to the second mounting electrode 66B and the second wiring electrode 68B. The first wiring electrode 68A is provided on the second surface 61B side of the mounting substrate 61 so as to cover the first connection electrode 67A and the first diffusion region 65A, and is connected to the first connection electrode 67A and the first diffusion region 65A. The second wiring electrode 68B is provided on the second surface 61B side of the mounting substrate 61 so as to cover the second connection electrode 67B and the second diffusion region 65B, and is connected to the second connection electrode 67B and the second diffusion region 65B.

The first terminal electrode 62A is provided on the second surface 61B side of the mounting substrate 61 so as to cover part of the first wiring electrode 68A, and is connected to the first wiring electrode 68A. The second terminal electrode 62B is provided on the second surface 61B side of the mounting substrate 61 so as to cover part of the second wiring electrode 68B, and is connected to the second wiring electrode 68B. The first and second terminal electrodes 62A and 62B are connected to electrodes of a circuit board on which the light-emitting device 60 is mounted.

In the light-emitting device 60, the first and second connection electrodes 67A and 67B are provided on a side surface of the mounting substrate 61. The first and second connection electrodes 67A and 67B are formed by forming grooves in the silicon base portion 64 when the silicon base portion 64 is in a wafer state through a process such as dicing, etching, sand blasting, or the like, and then filling the grooves with a metal through plating or the like. Accordingly, the first and second connection electrodes can be formed more easily than in a configuration in which the first and second connection electrodes are provided in through-holes in the silicon base material, as in the first embodiment.

A light-emitting device 70 according to a fifth embodiment of the present invention will be described hereinafter.

Although the light-emitting device 70 according to the present embodiment has the same circuit configuration as the light-emitting device 10 according to the first embodiment, the configurations of the mounting substrate is different. As such, although the light-emitting device 70 includes a mounting substrate 71 whose configuration is different from that of the mounting substrate 11 in the light-emitting device 10, the other configurations are almost identical.

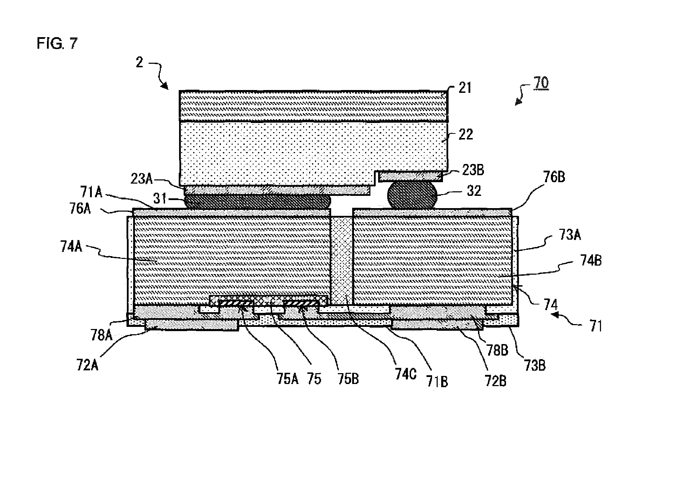

Fig. 7 is a schematic cross-sectional view illustrating the light-emitting device 70 according to the present embodiment, and illustrates a cross-section of the mounting substrate 71 and a side surface of the LED element 2. The light-emitting device 70 according to the present embodiment includes the LED element 2 and the mounting substrate 71. The mounting substrate 71 has a first surface 71A and a second surface 71B that is opposite from the first surface 71A. The mounting substrate 71 includes a first terminal electrode 72A, a second terminal electrode 72B, insulating films 73A and 73B, a silicon base portion 74, a semiconductor element portion 75, a first mounting electrode 76A, a second mounting electrode 76B, a first wiring electrode 78A, and a second wiring electrode 78B.

The insulating films 73A and 73B are configured of an insulative material such as glass. The insulating film 73A is provided so as to cover the entire side surface of the mounting substrate 71 as well as areas on the second surface 71B side of the mounting substrate 71 excluding first and second diffusion regions 75A and 75B of the silicon base portion 74. The insulating film 73B is provided on the second surface 71B side of the mounting substrate 71 so as to cover part of the insulating film 73A and part of the first and second wiring electrodes 78A and 78B.

The semiconductor element portion 75 is configured in the same manner as the semiconductor element portion 15 in the light-emitting device 10 according to the first embodiment, and includes the first diffusion region 75A and the second diffusion region 75B, and configures a Zener diode serving as the semiconductor-based electrostatic discharge protection element portion. The silicon base portion 74 has a rectangular plate shape when viewed from above, and includes a first semiconductor base portion 74A configured of low-resistance single-crystal silicon, a second semiconductor base portion 74B configured of low-resistance single-crystal silicon, and an insulative material portion 74C configured of an insulative material such as glass. The insulative material portion 74C is disposed between the first semiconductor base portion 74A and the second semiconductor base portion 74B, and insulates the first semiconductor base portion 74A and the second semiconductor base portion 74B from each other. The semiconductor element portion 75 is provided in the first semiconductor base portion 74A. The first semiconductor base portion 74A functions as a first connection electrode that electrically connects the first mounting electrode 76A and the first wiring electrode 78A. The second semiconductor base portion 74B functions as a second connection electrode that electrically connects the second mounting electrode 76B and the second wiring electrode 78B.

The first terminal electrode 72A is provided on the second surface 71B side of the mounting substrate 71 so as to cover part of the first wiring electrode 78A, and is connected to the first wiring electrode 78A. The second terminal electrode 72B is provided on the second surface 71B side of the mounting substrate 71 so as to cover part of the second wiring electrode 78B, and is connected to the second wiring electrode 78B. The first and second terminal electrodes 72A and 72B are connected to electrodes of a circuit board on which the light-emitting device 70 is mounted. The first and second mounting electrodes 76A and 76B are provided for mounting the LED element 2. The first mounting electrode 76A is provided on the first surface 71A side of the mounting substrate 71 so as to cover the first semiconductor base portion 74A. Accordingly, the first mounting electrode 76A is connected to the first semiconductor base portion 74A. The first mounting electrode 76A is electrically connected to the first element terminal electrode 23A by the bump 31. The second mounting electrode 76B is provided on the first surface 71A side of the mounting substrate 71 so as to cover the second semiconductor base portion 74B. Accordingly, the second mounting electrode 76B is connected to the second semiconductor base portion 74B. The second mounting electrode 76B is electrically connected to the second element terminal electrode 23B by the bump 32. The first wiring electrode 78A is provided on the second surface 71B side of the mounting substrate 71 so as to cover part of the first semiconductor base portion 74A and the first diffusion region 75A, and is connected to the first semiconductor base portion 74A and the first diffusion region 75A. The second wiring electrode 78B is provided on the second surface 71B side of the mounting substrate 71 so as to cover part of the second semiconductor base portion 74B and the second diffusion region 75B, and is connected to the second semiconductor base portion 74B and the second diffusion region 75B.

The first mounting electrode 76A, the first semiconductor base portion 74A, the first wiring electrode 78A, and the first terminal electrode 72A configure a first wiring portion. The first element terminal electrode 23A, which serves as the anode of the LED element 2, and the first diffusion region 75A, which serves as the cathode of the Zener diode, are connected by the first wiring portion. The second mounting electrode 76B, the second semiconductor base portion 74B, the second wiring electrode 78B, and the second terminal electrode 72B configure a second wiring portion. The second element terminal electrode 23B, which serves as the cathode of the LED element 2, and the second diffusion region 75B, which serves as the anode of the Zener diode, are connected by the second wiring portion.

According to the present embodiment, the silicon base portion 74 is configured of low-resistance single-crystal silicon, and the first and second semiconductor base portions 74A and 74B function as connection electrodes. This configuration can be realized by forming grooves in a low-resistance single-crystal silicon substrate through a process such as dicing, wet etching, sand blasting, or the like, filling the grooves with an insulative material such as polysilicon, glass, a resin, or the like, and forming insulative material portions, and others. The present embodiment does not require the use of dry etching, drilling, or the like, and thus the manufacturing cost can be reduced as compared to a case where through-holes are provided in the silicon base portion, as in the first embodiment.

Although the present invention can be carried out as described thus far, the embodiments described herein are merely examples, and the actions and effects of the present invention can be achieved by any light-emitting element device that falls within the scope of the appended claims.

### Reference Signs List

- 10, 40, 50, 60, 70: light-emitting device
- 2: LED element (semiconductor light-emitting diode element)
- 21: sapphire substrate
- 22: semiconductor compound layer
- 23A, 23B: element terminal electrode
- 31, 32: bump
- 3: Zener diode
- 4: varistor
- 11, 41, 51, 61, 71: mounting substrate
- 12A, 12B, 42A, 42B, 62A, 62B, 72A, 72B: terminal electrode
- 13A, 13B, 13C, 13D, 43A, 43B, 43C, 43D, 63A, 63B, 63C, 63D, 73A, 73B: insulating film
- 14, 64, 74: silicon base portion
- 14A, 14B, 44A, 44B: through-hole
- 15, 45, 55, 65, 75: semiconductor element portion
- 15A, 15B, 55A, 55B, 55C, 65A, 65B, 75A, 75B: diffusion region
- 16A, 16B, 46A, 46B, 66A, 66B, 76A, 76B: mounting electrode
- 17A, 17B, 47A, 47B, 67A, 67B: connection electrode
- 18A, 18B, 48A, 48B, 58A, 58B, 68A, 68B, 78A, 78B: wiring electrode
- 44: ceramic base portion
- 45A, 45B: varistor electrode
- 45C: varistor layer
- 58A1, 58B1, 58B2: comb-tooth electrode
- 74A, 74B: semiconductor base portion
- 74C: insulative material portion

## Claims

1. A light-emitting device comprising:
a light-emitting element; and
a mounting substrate, having a first surface on which the light-emitting element is mounted and a second surface that is opposite from the first surface, including a semiconductor-based electrostatic discharge protection element portion that is provided on the second surface side and is connected to the light-emitting element.

2. The light-emitting device according to claim 1,
wherein the light-emitting element is a semiconductor light-emitting diode element having an anode and a cathode;
the semiconductor-based electrostatic discharge protection element portion configures a Zener diode that includes an anode and a cathode;
the semiconductor light-emitting diode element and the Zener diode are connected in parallel; and
the cathode of the semiconductor light-emitting diode element is connected to the anode of the Zener diode and the anode of the semiconductor light-emitting diode element is connected to the cathode of the Zener diode.

3. The light-emitting device according to claim 1,
wherein the light-emitting element is a semiconductor light-emitting diode element having an anode and a cathode;
the semiconductor-based electrostatic discharge protection element portion configures a varistor; and
the semiconductor light-emitting diode element and the varistor are connected in parallel.
